# EUROPEAN PATENT APPLICATION

(11) **EP 3 778 216 A1**
(43) Date of publication of application: **17.02.2021**
(21) Application number: 19776182.8
(22) Date of filing: 08.02.2019
(51) Int. Cl.: B32B 9/00, C23C 16/30, C23C 16/42, C23C 16/44, C23C 16/505

(54) **LAMINATE AND METHOD FOR PRODUCING SAME**

(30) Priority: 30.03.2018 JP 2018067064
(71) Applicant: FUJIFILM CORPORATION, Minato-ku Tokyo 106-8620 (JP)
(72) Inventor: IWATA, Mitsuru, Ashigara-shi, Kanagawa 250-0193 (JP)
(74) Representative: Klunker IP Patentanwälte PartG mbB
(86) International application number: PCT/JP2019/004547
(87) International publication number: WO 2019/187693

(57) **Abstract**

Provided are a laminate having excellent scratch resistance and high manufacturing efficiency and a laminate manufacturing method.

The laminate includes a plastic substrate (11), a resin film (13), a first silicon oxide layer (21A), and a second silicon oxide layer (21B). The resin film (13) is provided on the plastic substrate (11). The resin film (13) is formed of a cured resin. The first silicon oxide layer (21A) is provided on a film surface (13a) of the resin film (13) on an opposite side from the plastic substrate (11). The second silicon oxide layer (21B) is provided on the first silicon oxide layer (21A). The second silicon oxide layer (21B) has a greater density and a smaller thickness than the first silicon oxide layer (21A).

## Description

### BACKGROUND OF THE INVENTION

### 1. Field of the Invention

The present invention relates to a laminate and a laminate manufacturing method.

### 2. Description of the Related Art

A scratch-resistant laminate having a hard coat layer is known. For example, JP2011-016257A discloses a laminate comprising a plastic substrate, an organosiloxane-based resin thermosetting film provided on the surface of the plastic substrate, and a plasma chemical vapor deposition (CVD) film provided on a film surface of the organosiloxane-based resin thermosetting film on an opposite side from the plastic substrate. The plasma CVD film is formed by exciting vapor of an organosilicon compound and oxygen gas using an apparatus for plasma polymerization under reduced pressure. The plasma CVD film is formed by continuously and gradually increasing the supply rates of the vapor of the organosilicon compound and the oxygen gas as the film formation time elapses.

JP2014-065281A discloses a laminate comprising a plastic substrate, a resin film formed of photocurable resin, and a silicon oxide film. The silicon oxide film has a structure in which two or greater unit silicon oxide films are laminated. The unit silicon oxide film is formed of a high density layer which is a silicon oxide layer having a relatively high density and a low density layer which is a low silicon oxide layer, and the high density layer is disposed on the resin film side. The density of the low density layer continuously decreases in the thickness direction as the distance from the high density layer increases. In JP2014-065281A, the plastic substrate on which the resin film is formed on the surface thereof is transported and the silicon oxide film is formed on the film surface of the resin film on the opposite side from the plastic substrate. After the high density layer which is the silicon oxide layer is formed by the atmospheric pressure plasma processing apparatus to which a gaseous organosilicon compound is supplied, by performing cooling in an atmosphere containing water vapor out of the discharge plasma region, a part of the exposed surface side of the high density layer is generated as the low density layer, and each of unit silicon oxide films is formed.

### SUMMARY OF THE INVENTION

The laminate disclosed in JP2011-016257A is manufactured by so-called reduced pressure plasma processing (vacuum plasma processing), which is plasma polymerization under reduced pressure, therefore has poor manufacturing efficiency and is difficult to mass manufacture. On the other hand, the atmospheric pressure plasma processing used in JP2014-065281A is excellent in manufacturing efficiency as compared with the reduced pressure plasma processing. However, in the laminate disclosed in JP2014-065281A, it takes time for a low density layer producing step performed after the high density layer is formed by the reduced pressure plasma processing, and since a plurality of unit silicon oxide films are laminated on each other, it is necessary to perform low density layer producing step a plurality of times, therefore the manufacturing efficiency is still poor.

An object of the present invention is to provide a laminate having scratch resistance and excellent in manufacturing efficiency, and a laminate manufacturing method.

In order to solve the above described object, a laminate according to an aspect of the present invention comprises a plastic substrate, a resin film, a first silicon oxide layer, and a second silicon oxide layer. The resin film is provided on the plastic substrate and formed of a cured resin. The first silicon oxide layer is provided on a film surface of the resin film on an opposite side from the plastic substrate. The second silicon oxide layer is provided on the first silicon oxide layer. The second silicon oxide layer has a greater density and a smaller thickness than the first silicon oxide layer.

It is preferable that the first silicon oxide layer have a density in a range of 1.7 g/cm³ or greater and 2.3 g/cm³ or smaller, and a thickness of at least 300 nm.

It is preferable that a silicon oxide film in which at least two silicon oxide layers including the first silicon oxide layer and the second silicon oxide layer are laminated in a thickness direction be provided. It is preferable that the silicon oxide layer that forms a film surface of the silicon oxide film on an opposite side from the resin film have a density in a range of 2.6 g/cm³ or greater and 2.8 g/cm³ or smaller and a thickness of at most 500 nm.

It is preferable that the laminate further comprise a first boundary layer between the first silicon oxide layer and the second silicon oxide layer. The first boundary layer is formed of silicon oxide. The first boundary layer has a smaller thickness than the first silicon oxide layer and the second silicon oxide layer. The first boundary layer has a density greater than a density of the first silicon oxide layer and in a range of 95% or greater and 105% or smaller of a density of the second silicon oxide layer.

It is preferable that the first boundary layer have a density that gradually increases from the first silicon oxide layer side to the second silicon oxide layer side.

It is preferable that the silicon oxide film further include a third silicon oxide layer and a second boundary layer. The third silicon oxide layer is provided on the second silicon oxide layer. The third silicon oxide layer has a greater density and a smaller thickness than the second silicon oxide layer. The second boundary layer is provided between the second silicon oxide layer and the third silicon oxide layer. The second boundary layer is formed of silicon oxide. The second boundary layer has a smaller thickness than the second silicon oxide layer and the third silicon oxide layer and a density greater than a density of the second silicon oxide layer and in a range of 95% or greater and 105% or smaller of a density of the third silicon oxide layer.

It is preferable that the second boundary layer have a smaller thickness than the first boundary layer.

A laminate manufacturing method according another aspect of the invention, for forming a silicon oxide layer while transporting a plastic substrate having a resin film formed of a cured resin, comprises a resin film forming step, a first silicon oxide layer forming step, and a second silicon oxide layer forming step. In the resin film forming step, a coating liquid containing a curable compound is applied on the plastic substrate and the applied coating film is cured to form the resin film. In the first silicon oxide layer forming step, the plastic substrate on which the resin film is formed is transported to a first layer forming apparatus which forms the silicon oxide layer by supplying a gaseous organosilicon compound and generating plasma under atmospheric pressure, and a first silicon oxide layer is formed on a film surface of the resin film. In the second silicon oxide layer forming step, a second silicon oxide layer is formed on the first silicon oxide layer by a second layer forming apparatus disposed downstream of the first layer forming apparatus in a transport direction of the plastic substrate. The organosilicon compound is supplied to the second layer forming apparatus with a flow rate smaller than a flow rate with respect to the first layer forming apparatus.

It is preferable that the first layer forming apparatus and the second layer forming apparatus have a power supply for applying an alternating current voltage, and a frequency of the alternating current voltage be at most 1 MHz.

It is preferable that the plastic substrate on which the first silicon oxide layer is formed be guided to a surface treatment apparatus that is disposed between the first layer forming apparatus and the second layer forming apparatus, and generates plasma to reform a surface of the silicon oxide layer, a flow rate of the organosilicon compound supplied to the surface treatment apparatus be made to 0 g/min or greater and 0.9 g/min or smaller to produce, on the first silicon oxide layer, a boundary layer that has a smaller thickness than the first silicon oxide layer and the second silicon oxide layer, and a density greater than a density of the first silicon oxide layer and in a range of 95% or greater and 105% or smaller of a density of the second silicon oxide layer.

According to the present invention, it is possible to obtain a laminate having scratch resistance and excellent in manufacturing efficiency.

### BRIEF DESCRIPTION OF THE DRAWINGS

Fig. 1 is an explanatory diagram of a layer structure of a laminate.
Fig. 2 is an explanatory diagram of a layer structure of a silicon oxide film.
Fig. 3 is a graph of the density of a silicon oxide film.
Fig. 4 is a schematic diagram of a resin film forming apparatus.
Fig. 5 is an explanatory diagram of a method for forming a silicon oxide film.
Fig. 6 is a schematic diagram of a silicon oxide film forming unit.
Fig. 7 is a schematic partial cross-sectional diagram of a layer forming apparatus.

### DESCRIPTION OF THE PREFERRED EMBODIMENTS

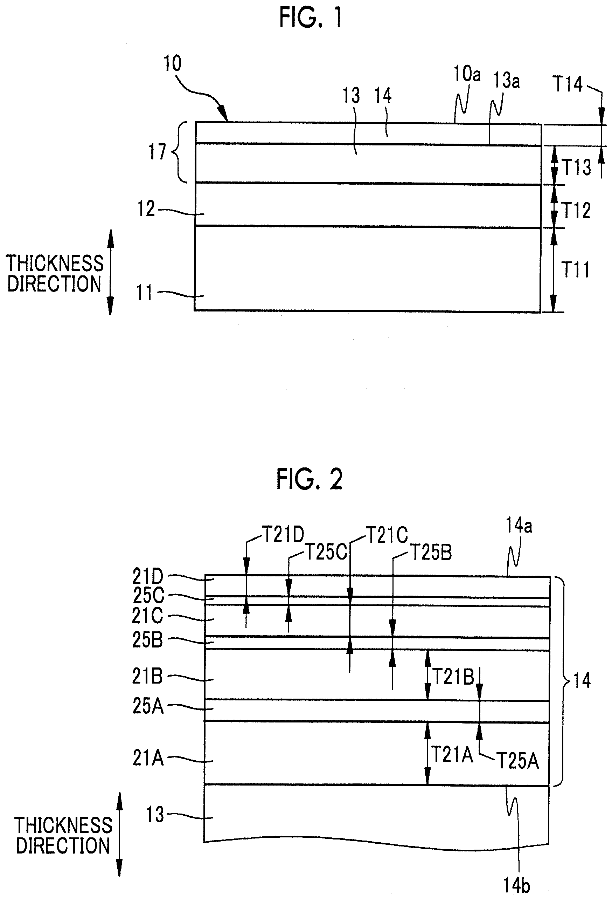

A laminate 10 shown in Fig. 1 is an embodiment of the present invention. The laminate 10 has a multi-layer structure in which a plastic substrate 11, a base layer 12, a resin film 13, and a silicon oxide film 14 are laminated in this order in a thickness direction. The laminate 10 can be used as a hard coat member (scratch resistant member) that is assembled to, for example, a window of a vehicle or a lens of eyeglasses. In a case where the laminate 10 is used as a hard coat member, the laminate 10 is assembled to another member with the silicon oxide film 14 facing outward and the plastic substrate 11 facing inside.

The plastic substrate 11 is a support that supports the resin film 13 and the silicon oxide film 14 having a small thickness as described below. The plastic substrate 11 also serves as a support for the coating film in a case where the resin film 13 is formed by coating. The material of the plastic substrate 11 is not particularly limited as long as it is plastic (plastic material), and a thermoplastic resin (polymer) or the like can be used. Examples of the thermoplastic resin include various plastics (resin or polymer) such as polycarbonate (hereinafter referred to as a PC), polyester (for example, polyethylene terephthalate (PET), or polyethylene naphthalate (PEN)), and polymethyl methacrylate resin (PMMA). Since PC has excellent transparency, is lighter in weight, and has better impact resistance and workability than glass, PC is often used as a substitute for glass. Therefore, also in the embodiment, PC is used as the plastic substrate 11 in order to form a laminate that can be used instead of glass, for example, for optical use.

A thickness T11 of the plastic substrate 11 is not particularly limited as long as the function as a support is not impaired, and is in the range of 100 µm or greater and 50 mm or smaller, for example. In the embodiment, the thickness T11 is 300 µm.

The resin film 13 is for buffering in a case where an external force such as an impact is applied to the laminate 10, that is, for softening the applied force by dispersing the applied force. The resin film 13 may be provided directly (in a state of being in close contact) on the plastic substrate 11, or may be provided on the plastic substrate 11 via the base layer 12 as in the embodiment.

The resin film 13 is formed of a cured resin, and may contain additives such as an ultraviolet (UV) absorber and an antistatic agent in addition to the cured resin. The cured resin may be either a photocurable resin or a thermosetting resin, and is a photocurable resin in the embodiment. The photocurable resin is a resin (polymer) produced by emitting light to a photocurable compound that is cured by irradiation with light. The thermosetting resin is a resin (polymer) produced by heating a thermosetting compound that is cured by heating. Since the resin film 13 is formed of a cured resin, in a case where an external force such as an impact is applied to the laminate 10, the external force is buffered as compared with the case where the resin film is formed of a plastic resin, and as a result, the scratch resistance of a surface (hereinafter referred to as a first surface) 10a of the laminate 10 on the silicon oxide film 14 side is ensured.

The photocurable resin is not particularly limited, and for example, an acrylic resin or an organosiloxane resin is used. In the embodiment, an acrylic resin is used. The thermosetting resin is not particularly limited, and for example, an organosiloxane resin, a melanin resin, a urethane resin, or an alkyd resin is used.

A thickness T13 of the resin film 13 is preferably 1 µm or greater, thereby the buffering function described above in a case where the impact is applied to the laminate 10 is further reliable. The thickness T13 is more preferably in a range of 1 µm or greater and 20 µm or smaller, and still more preferably in a range of 3 µm or greater and 8 µm or smaller. In the embodiment, the thickness T13 is 5 µm.

The base layer 12 between the plastic substrate 11 and the resin film 13 is to enhance the adhesive strength between the plastic substrate 11 and the resin film 13. In a case where the adhesive strength between the plastic substrate 11 and the resin film 13 is sufficient, the base layer 12 can be omitted. The material of the base layer 12 is not particularly limited as long as it can adhere to both of the plastic substrate 11 and the resin film 13, for example, a urethane resin, an acrylic resin, an epoxy resin, a polyester resin, a melanin resin, or an amino resin can be used. In the embodiment, an acrylic resin is used.

In the embodiment, a compound cured by irradiation with ultraviolet rays (ultraviolet curable compound) is used as the photocurable compound that forms the resin film 13, therefore, the ultraviolet absorber is contained in the base layer 12. Therefore, the amount of ultraviolet rays that enter the plastic substrate 11 is reduced. Ultraviolet deterioration of the plastic substrate 11 is suppressed by reducing the amount of ultraviolet rays entering the plastic substrate 11. Also, ultraviolet deterioration of the plastic substrate 11 under usage environment of the laminate 10 is suppressed by containing the ultraviolet absorber in the base layer 12. As described above, the base layer 12 may have a function other than a function of improving the adhesive strength between the plastic substrate 11 and the resin film 13, and can be provided in a case where the adhesive strength between the plastic substrate 11 and the resin film 13 is not required to be improved.

The silicon oxide film 14 is formed of silicon oxide in a film shape and is for improving scratch resistance. The silicon oxide film 14 is provided on a film surface 13a of the resin film 13 on an opposite side from the plastic substrate 11. As described above, since the resin film 13 improves the scratch resistance by buffering the force applied from the outside, the silicon oxide film 14 and the resin film 13 cooperate to bear the scratch resistance. That is, the resin film 13 and the silicon oxide film 14 form the hard coat portion (scratch resistant portion) 17 of the laminate 10.

The silicon oxide film 14 comprises at least two silicon oxide layers laminated in the thickness direction, and in the embodiment, as shown in Fig. 2, the silicon oxide film 14 comprises four layers of a first silicon oxide layer 21A, a second silicon oxide layer 21B, a third silicon oxide layer 21C, and a fourth silicon oxide layer 21D in this order from the resin film 13 side. In the following description, the first silicon oxide layer 21A to the fourth silicon oxide layer 21D are referred to as the silicon oxide layer 21 in a case where the silicon oxide layers are not distinguished. The number of layers of the silicon oxide layer 21 is not limited to four in the embodiment, and may be two, three, or five or greater.

The silicon oxide film 14 further comprises a first boundary layer 25A, a second boundary layer 25B, and a third boundary layer 25C, which are sequentially arranged from the resin film 13 side. In the following description, the first boundary layer 25A to the third boundary layer 25C are referred to as the boundary layer 25 in a case where the boundary layers are not distinguished. The first boundary layer 25A is provided between the first silicon oxide layer 21A and the second silicon oxide layer 21B, the second boundary layer 25B is provided between the second silicon oxide layer 21B and the third silicon oxide layer 21C, and the third boundary layer 25C is provided between the third silicon oxide layer 21C and the fourth silicon oxide layer 21D. As described above, the laminate may comprise the boundary layer 25 between a plurality of silicon oxide layers 21 respectively.

The boundary layer 25 is for improving the adhesive strength between the silicon oxide layers 21, and at least one of the first boundary layer 25A to the third boundary layer 25C can be omitted. Therefore, each of the second silicon oxide layer 21B to the fourth silicon oxide layer 21D is directly disposed on the first silicon oxide layer 21A to the third silicon oxide layer 21C in a case where the boundary layer 25 is not provided, and is disposed on the first silicon oxide layer 21A to the third silicon oxide layer 21C through the boundary layer 25 in a case where the boundary layer 25 is provided.

Each of the first silicon oxide layer 21A to the fourth silicon oxide layer 21D is formed to have a constant density in the thickness direction. The density is the mass per unit volume. In the embodiment, the density is measured by an X-ray reflectometry method using an X-ray diffractometer ATX-E manufactured by Rigaku Corporation for evaluating thin film structure.

The second silicon oxide layer 21B has a greater density and a smaller thickness than the first silicon oxide layer 21A provided on the film surface 13a of the resin film 13. From only the viewpoint of improving the scratch resistance, the greater the thickness of the silicon oxide layer 21, the better, therefore a thickness T21B of the second silicon oxide layer 21B is made greater, for example, may be the same as the thickness T21A of the first silicon oxide layer 21A. However, in the embodiment, the thickness T21B is made smaller than the thickness T21A, and the second silicon oxide layer 21B has a greater density than the first silicon oxide layer 21A, therefore the scratch resistance is improved and the layer formation can be efficiently performed by using the plasma generation under the atmospheric pressure as described below, and the manufacturing efficiency of the laminate 10 is improved. By setting the thickness and the density as described above, both scratch resistance and manufacturing efficiency are compatible.

The third silicon oxide layer 21C has a greater density than the second silicon oxide layer 21B and the thickness T21C is smaller than the thickness T21B. Similarly, the fourth silicon oxide layer 21D has a greater density than the third silicon oxide layer 21C, and the thickness T21D is smaller than the thickness T21C. As described above, the silicon oxide layer 21 is formed to have a greater density and a smaller thickness as the silicon oxide layer 21 is separated from the resin film 13, so that the laminate 10 has the improved scratch resistance and excellent manufacturing efficiency.

It is preferable that the first silicon oxide layer 21A have a density in a range of 1.7 g/cm³ or greater and 2.3 g/cm³ or smaller, and a thickness T21A of at least 300 nm. In a case where the thickness T21A is 300 nm or greater, the scratch resistance is reliably improved in a state where the manufacturing efficiency is maintained, as compared with a case the thickness T21A is smaller than 300 nm. In a case where a density is 1.7 g/cm³ or greater, the scratch resistance is reliably obtained even in a case where the thickness T21A is small, for example, 300 nm. In a case where a density is 2.3 g/cm³ or smaller, as compared with a case where the density is greater than 2.3 g/cm³, the adhesive strength with the resin film 13 is maintained and peeling from the resin film 13 is further suppressed. The density of the first silicon oxide layer 21A is more preferably in a range of 1.7 g/cm³ or greater and 2.3 g/cm³ or smaller, and still more preferably in a range of 1.9 g/cm³ or greater and 2.1 g/cm³ or smaller. The thickness T21A is more preferably in a range of 300 nm or greater and 2000 nm or smaller, and still more preferably in a range of 400 nm or greater and 800 nm or smaller.

It is preferable that the silicon oxide layer 21 (in the embodiment, the fourth silicon oxide layer 21D) that forms a film surface (hereinafter, referred to as a first film surface) 14a of the silicon oxide film 14 on an opposite side from the resin film 13 have a density in a range of 2.6 g/cm³ or greater and 2.8 g/cm³ or smaller and a thickness of at most 500 nm. By suppressing the thickness T24D of the fourth silicon oxide layer 21D to be 500 nm or smaller, it is possible to efficiently form a layer by using plasma generation under atmospheric pressure as described below, and an effect of improving the manufacturing efficiency is improved. In a case where a density is 2.6 g/cm³ or greater, as compared with a case where the density is smaller than 2.6 g/cm³, the scratch resistance is reliably obtained even in a case where the thickness T21D is small, for example, 500 nm. In a case where the density is 2.8 g/cm³ or smaller, as compared with a case where the density is greater than 2.8 g/cm³, the adhesive strength with other silicon oxide layer 21 (in the embodiment, the first silicon oxide layer 21A, the second silicon oxide layer 21B, and the third silicon oxide layer 21C) is further maintained, peeling from other silicon oxide layer 21 is reliably prevented. In Fig. 2, the film surface (hereinafter referred to as a second film surface) of the silicon oxide film 14 on the resin film 13 side is denoted by reference numeral 14b.

The thickness of the silicon oxide layer 21 forming the first film surface 14a is more preferably in the range of 200 nm or greater and 500 nm or smaller.

Each of the first boundary layer 25A to the third boundary layer 25C is formed of silicon oxide. In the first boundary layer 25A between the first silicon oxide layer 21A and the second silicon oxide layer 21B, it is preferable that the thickness T25A be smaller than the thickness T21A and the thickness T21B, and the density be greater than the density of the first silicon oxide layer 21A and be in a range of 95% or greater and 105% or smaller of the density of the second silicon oxide layer 21B. Therefore, the adhesive strength between the first silicon oxide layer 21A and the second silicon oxide layer 21B is further improved.

In the second boundary layer 25B between the second silicon oxide layer 21B and the third silicon oxide layer 21C, it is preferable that the thickness T25B be smaller than the thickness T21B and the thickness T21C, and the density be greater than the density of the second silicon oxide layer 21B and be in a range of 95% or greater and 105% or smaller of the density of the third silicon oxide layer 21C. Similarly, in the third boundary layer 25C, it is preferable that the thickness T25C be smaller than the thickness T21C and the thickness T21D, and the density be greater than the density of the third silicon oxide layer 21C and be in a range of 95% or greater and 105% or smaller of the density of the fourth silicon oxide layer 21D.

As described above, it is preferable that the boundary layer 25 located between the two silicon oxide layers 21 have a thickness smaller than each thickness of the silicon oxide layers 21 located on both sides of the boundary layer 25, and have a density greater than one silicon oxide layer 21 on the resin film 13 side and in a range of 95% or greater and 105% or smaller of the density of the other silicon oxide layer 21 on the opposite side from the resin film 13. Therefore, the adhesive strength between one silicon oxide layer 21 and the other silicon oxide layer 21 is further improved.

The thickness T25B is preferably smaller than the thickness T25B. Similarly, the thickness T25C is preferably smaller than the thickness T25B. As described above, by forming the boundary layer 25 with a smaller thickness as the boundary layer 25 is separated from the resin film 13, the formation efficiency in the surface treatment using plasma, which will be described below, increases as compared with the case where the thickness is constant. As a result, the laminate 10 having excellent manufacturing efficiency can be obtained. Further, by increasing the density of the boundary layer 25 as the boundary layer 25 is separated from the resin film 13, even in a case where the thickness decreases as the boundary layer 25 is separated from the resin film 13, the scratch resistance is reliably improved.

In addition, in the first boundary layer 25A having the greatest thickness among the boundary layers 25, it is preferable that the thickness T25A be smaller than the thickness of the silicon oxide layer 21 having the smallest thickness (the fourth silicon oxide layer 21D in the embodiment) of the silicon oxide layers 21. Thus, the very thin boundary layer 25 can be efficiently formed by the surface treatment using plasma described below.

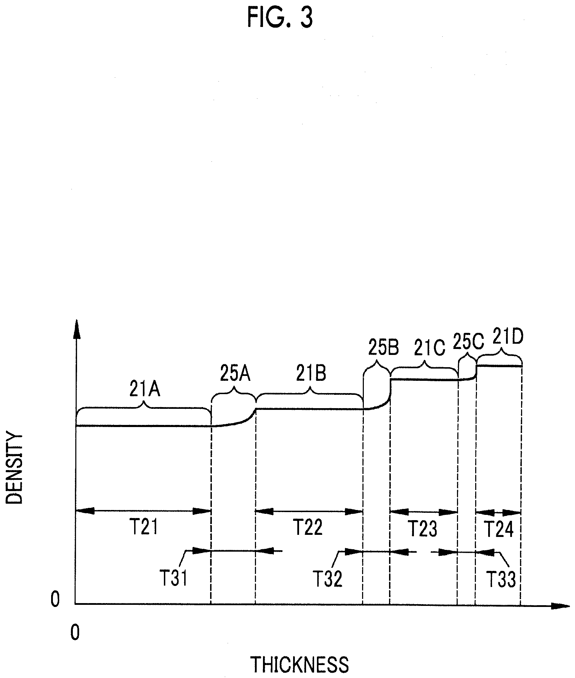

The density of the first boundary layer 25A may be constant from the first silicon oxide layer 21A side toward the second silicon oxide layer 21B side, or may gradually increase stepwise. In the embodiment, as shown in Fig. 3, the density increases gradually from the first silicon oxide layer 21A side toward the second silicon oxide layer 21B side, therefore, the adhesive strength between the first silicon oxide layer 21A and the second silicon oxide layer 21B is further improved.

Similarly, the density of the second boundary layer 25B may be constant from the second silicon oxide layer 21B side toward the third silicon oxide layer 21C side, or may gradually increase stepwise, but preferably increase gradually as shown in Fig. 3. Similarly, the density of the third boundary layer 25C may be constant from the third silicon oxide layer 21C side toward the fourth silicon oxide layer 21D side, or may gradually increase, but preferably increases gradually. This is because the adhesive strength between the second silicon oxide layer 21B and the third silicon oxide layer 21C and the adhesive strength between the third silicon oxide layer 21C and the fourth silicon oxide layer 21D are further improved.

The laminate 10 has the above described configuration of the silicon oxide film 14, so that the fourth silicon oxide layer 21D forming the first surface 10a on the outermost surface among the first silicon oxide layer 21A to the fourth silicon oxide layer 21D has the smallest thickness and the greatest density. Therefore, the laminate 10 exhibits excellent scratch resistance while suppressing the thickness of the silicon oxide film 14.

A boundary (interface) between the silicon oxide layer 21 and the boundary layer 25 may not be visually recognized. In particular, the boundary between the first silicon oxide layer 21A and the first boundary layer 25A, the boundary between the second silicon oxide layer 21B and the second boundary layer 25B, and the boundary between the third silicon oxide layer 21C and the third boundary layer 25C are often not visually recognized. As described above, in a case where the boundary between the layers cannot be visually recognized, the density is obtained in the thickness direction, density profile data (such as a graph) in the thickness direction as shown in Fig. 3 is created, and a certain area having a constant density in the thickness direction may be regarded as the silicon oxide layer 21, and an area where a density changes may be regarded as the boundary layer 25. That is, the boundary between the layers is a conceptual boundary based on the density profile as described above in a case where the boundary cannot be visually recognized.

The laminate 10 is manufactured by the following manufacturing method, for example. The laminate manufacturing method includes a base layer forming step, a resin film forming step, and a silicon oxide film forming step in this order. In the base layer forming step, the base layer 12 (see Fig. 1) is formed on the plastic substrate 11. In a case where the base layer 12 is not provided, the base layer forming step is omitted. In the resin film forming step, the resin film 13 (see Fig. 1) is formed on the base layer 12. In a case where the base layer 12 is provided as in the embodiment example, in the resin film forming step, the resin film 13 is formed on the plastic substrate 11 via the base layer 12, and in a case where the base layer 12 is not provided, the resin film 13 is formed directly on the plastic substrate 11. In the silicon oxide film forming step, the silicon oxide film 14 (see Fig. 1) is formed on the film surface 13a of the resin film 13 (see Fig. 1). Hereinafter, each step will be described.

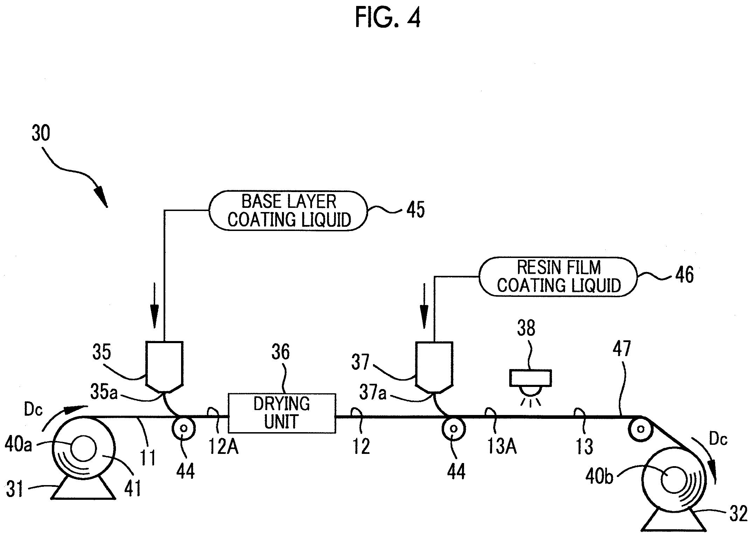

A coating unit 30 shown in Fig. 4 is an example for the base layer forming step and the resin film forming step. In this example, a base layer 12 and a resin film 13 are sequentially formed on a long plastic substrate 11. However, the base layer 12 and the resin film 13 may be sequentially formed on the sheet-shaped plastic substrate 11.

The coating unit 30 includes a delivery device 31, a winding device 32, a first coating die 35, a drying unit 36, a second coating die 37, and a light source 38. The delivery device 31 is for delivering the plastic substrate 11 in the longitudinal direction. A substrate roll 41 in which the plastic substrate 11 is wound around a winding core 40a is set in the delivery device 31. The delivery device 31 delivers the plastic substrate 11 from the substrate roll 41 by rotating the winding core 40a of the set substrate roll 41.

The winding device 32 is for winding the plastic substrate 11 on which the base layer 12 and the resin film 13 are formed into a roll shape. A winding core 40b is set on the winding device 32, and the guided plastic substrate 11 is wound around the winding core 40b by rotating the winding core 40b.

The plastic substrate 11 is transported in the longitudinal direction by the delivery device 31 and the winding device 32. Further, in the embodiment, a plurality of rollers 44 for supporting the plastic substrate 11 are disposed in a transport path. At least one of the rollers 44 may be a driving roller that rotates in the circumferential direction, and the plastic substrate 11 may be transported by the driving roller.

The first coating die 35, the drying unit 36, the second coating die 37, and the light source 38 are arranged in this order from the upstream side in a transport direction Dc of the plastic substrate 11. The first coating die 35 continuously discharges a coating liquid (hereinafter, referred to as a base layer coating liquid) 45 for forming the base layer 12 from an outflow port 35a directed to the transport path. The base layer coating liquid 45 is continuously discharged onto the transported plastic substrate 11 to form the coating film 12A.

The base layer coating liquid 45 is a solution in which the base layer material forming the base layer 12 is dissolved in a solvent. The base layer material is not particularly limited, for example, the above-described a urethane resin, an acrylic resin, an epoxy resin, a polyester resin, a melanin resin, an amino resin, or the like forming the base layer 12 is used, and an acrylic resin is used in the embodiment. As the solvent, for example, toluene, xylene, or butanol is used alone or in combination, and in the embodiment, a mixture of toluene and butanol is used. The concentration of the base layer material in the base layer coating liquid 45 is not particularly limited and is, for example, in the range of 30% or greater and 70% or smaller, and is 45% in the embodiment. The concentration (unit: %) of the base layer material in the base layer coating liquid 45 is calculated by {M1/(M1 + M2)} × 100 in a case where the mass of the base layer material is M1 and the mass of the solvent is M2.

The drying unit 36 is for forming the base layer 12 by drying the coating film 12A. The drying unit 36 includes a chamber (not shown) to which a dry gas (for example, air) is supplied. The temperature of the supplied gas is adjusted, and the coating film 12A on the plastic substrate 11 is dried by passing through the chamber to be the base layer 12.

The second coating die 37 continuously discharges a coating liquid (hereinafter, referred to as a resin film coating liquid) 46 for forming the resin film 13 from an outflow port 37a directed to the transport path. The resin film coating liquid 46 is continuously discharged onto the base layer 12 formed on the transported plastic substrate 11 to form the coating film 13A.

The resin film coating liquid 46 is a liquid containing a curable compound. In a case where the curable compound is a solid, a liquid in which the curable compound is dissolved in a solvent is used as the resin film coating liquid 46. In a case where the curable compound is a liquid, no solvent may be used.

The curable compound is a photocurable compound in a case where the resin film 13 is formed of a photocurable resin, and a thermosetting compound in a case where the resin film 13 is formed of a thermosetting resin.

The photocurable compound is not particularly limited, and for example, each monomer and each oligomer of an acrylic resin and an organosiloxane resin are used. In the embodiment, a monomer of an acrylic resin is used. As the solvent of the photocurable compound, for example, toluene, xylene, or butanol is used. The thermosetting compound is not particularly limited, and for example, each monomer and each oligomer of an organosiloxane resin, a melanin resin, a urethane resin, or an alkyd resin are used. In a case where the resin film coating liquid 46 contains a solvent, the concentration of the curable compound is not particularly limited.

The light source 38 is for forming the resin film 13 by curing the curable compound of the coating film 13A. Since the acrylic resin monomer used in the embodiment is a compound that is cured by ultraviolet rays, the light source 38 that emits ultraviolet rays is used. By passing through the light source 38, the coating film 13A is irradiated with ultraviolet rays, therefore the photocurable compound is cured and the resin film 13 is formed (resin film forming step). In a case where the resin film coating liquid 46 contains a solvent, a drying unit (not shown) similar to the drying unit 36 is disposed on the upstream side and/or the downstream side of the light source 38, and the solvent may be evaporated from the coating film 13A by the drying unit.

The plastic substrate 11 on which the resin film 13 is formed is guided to the winding device 32 and wound around the winding core 40b in a roll shape. The formed roll is hereinafter referred to as an intermediate roll. The intermediate 47, which is a laminate of the plastic substrate 11, the base layer 12, and the resin film 13 and is wound around the intermediate roll, is cut into a sheet shape by a cutting device (not shown), and is supplied to a silicon oxide film forming facility. The intermediate 47 may be cut into a sheet shape with the winding device 32 replaced with a cutting device without passing through the intermediate roll.

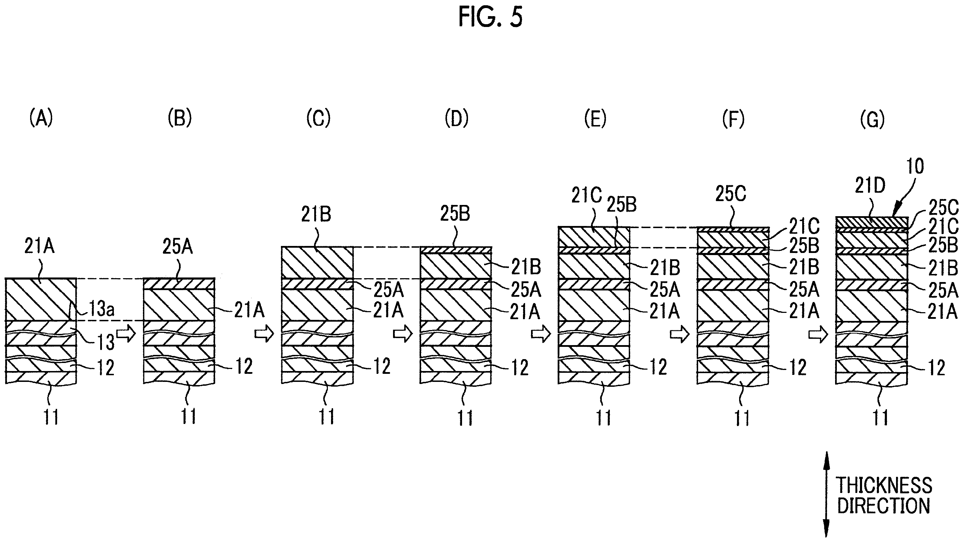

The order of forming the silicon oxide film 14 will be described with reference to Fig. 5. As shown in (A) of Fig. 5, the first silicon oxide layer 21A is formed on the film surface 13a of the resin film 13, and thereafter, as shown in (B) of Fig. 5, a partial area of the first silicon oxide layer 21A on the opposite side from the resin film 13 in the thickness direction is formed as the first boundary layer 25A. As described above, the first boundary layer 25A is a layer formed from the first silicon oxide layer 21A, and the portion that does not become the first boundary layer 25A is the first silicon oxide layer 21A of the laminate 10.

As shown in (C) of Fig. 5, the second silicon oxide layer 21B is formed on the surface of the first boundary layer 25A, and thereafter, as shown in (D) of Fig. 5, a partial area of the second silicon oxide layer 21B on the opposite side from the resin film 13 in the thickness direction is formed as the second boundary layer 25B. As described above, similar to the first boundary layer 25A, the second boundary layer 25B is a layer formed from the second silicon oxide layer 21B, and the portion that does not become the second boundary layer 25B is the second silicon oxide layer 21B of the laminate 10. Similarly, the third silicon oxide layer 21C and the third boundary layer 25C are sequentially formed (see (E) and (F) of Fig. 5). Then, the fourth silicon oxide layer 21D is formed on the surface of the formed third boundary layer 25C, and the laminate 10 is obtained (see (G) of Fig. 5).

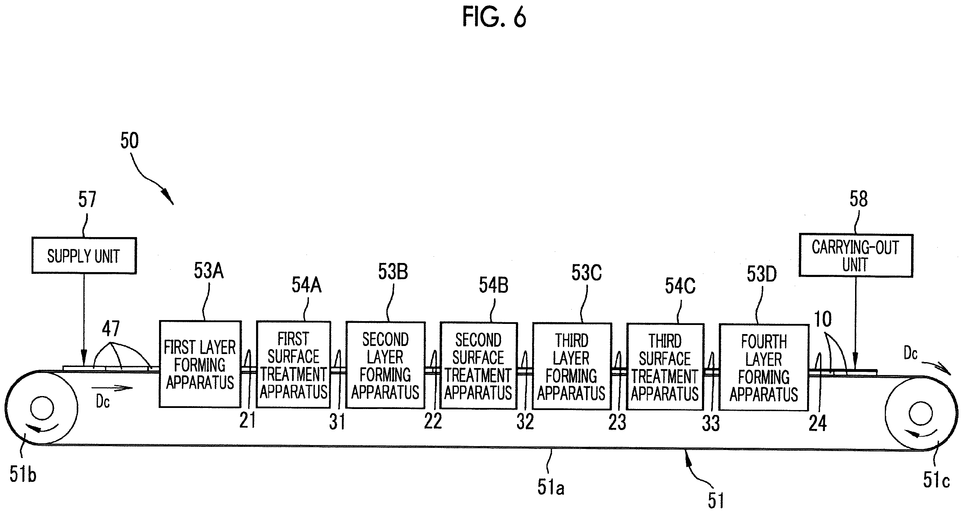

The silicon oxide film forming unit 50 shown in Fig. 6 is an example of facility for forming the silicon oxide film 14, and is used to obtain the laminate 10. The silicon oxide film forming unit 50 comprises a transport unit 51 that transports the mounted intermediate 47 having a sheet shape, the first layer forming apparatus 53A to the fourth layer forming apparatus 53D, the first surface treatment apparatus 54A to the third surface treatment apparatus 54C, a supply unit 57, and a carrying-out unit 58.

The first layer forming apparatus 53A to the fourth layer forming apparatus 53D have the same configuration, and in the following description, in a case where the first layer forming apparatus 53A to the fourth layer forming apparatus 53D are not distinguished from each other, the apparatus is described as the layer forming apparatus 53. Further, the first surface treatment apparatus 54A to the third surface treatment apparatus 54C have the same configuration, and in a case where the first surface treatment apparatus 54A to the third surface treatment apparatus 54C are not distinguished in the following description, the apparatus is described as the surface treatment apparatus 54. Since the intermediate 47 comprises the plastic substrate material 11, transporting the intermediate 47 is the same as transporting the plastic substrate material 11, and the transport direction and transport path of the intermediate 47 are the same as the transport direction Dc and the transport path of the plastic substrate 11. Therefore, in the following description, these transport direction and the transport path are collectively referred to as the transport direction Dc and the transport path.

The first layer forming apparatus 53A, the second layer forming apparatus 53B, the third layer forming apparatus 53C, and the fourth layer forming apparatus 53D are provided in this order from the upstream side in the transport direction Dc. In addition, the first surface treatment apparatus 54A is provided between the first layer forming apparatus 53A and the second layer forming apparatus 53B, the second surface treatment apparatus 54B is provided between the second layer forming apparatus 53B and the third layer forming apparatus 53C, and the third surface treatment apparatus 54C is provided between the third layer forming apparatus 53C and the fourth layer forming apparatus 54D.

The transport unit 51 is for transporting the intermediate 47, and comprises a transport belt 51a formed in an annular shape, and a first roller 51b and a second roller 51c that move the transport belt 51a in the longitudinal direction. The transport belt 51a is stretched around the peripheral surfaces of the first roller 51b and the second roller 51c. The first roller 51b and the second roller 51c have a drive unit (not shown) such as a motor, and rotate in the circumferential direction under the control by the drive unit. As a result, the transport belt 51a moves, and the mounted intermediate 47 is transported.

The supply unit 57 supplies the sheet-shaped intermediate 47 to the transport belt 51a. The supply unit 57 mounts, for example, one intermediate 47 on the belt surface of the transport belt 51a near the first roller 51b, and the mounted intermediate 47 is transported to the second roller 50c by the moving transport belt 51a. The intermediate 47 is mounted on the transport belt 51a with the plastic substrate 11 facing downward and the resin film 13 facing upward. Therefore, the intermediate 47 passes through the first layer forming apparatus 53A, the first surface treatment apparatus 54A, the second layer forming apparatus 53B, the second surface treatment apparatus 54B, the third layer forming apparatus 53C, the third surface treatment apparatus 54C, and the fourth layer forming apparatus 53D, which are disposed on the transport path, in this order, and is subjected to predetermined processing, and the laminate 10 is manufactured. As described above, the processing is performed by the intermediate passing through the first layer forming apparatus 53A to the fourth layer forming apparatus 53D and the first surface treatment apparatus 54A to the third surface treatment apparatus 54C which are disposed on the transport path, therefore, the manufacturing efficiency is excellent.

Each distance between the first layer forming apparatus 53A, the first surface treatment apparatus 54A, the second layer forming apparatus 53B, the second surface treatment apparatus 54B, the third layer forming apparatus 53C, the third surface treatment apparatus 54C, and the fourth layer forming apparatus 53D is not particularly limited. From the viewpoint of manufacturing efficiency, the distances are preferably as short as possible. In the embodiment, the distance is 50 cm, for example.

In the embodiment, the intermediate 47 to be supplied next is mounted in a state where the leading end thereof is in contact with the rear end of the previously mounted intermediate 47 in the transport direction Dc, therefore, the manufacturing efficiency of the laminate 10 further increases. However, the intermediates 47 may be mounted in a state of being separated from each other in the transport direction Dc. A plurality of intermediates 47 may be mounted in a state of being arranged in the depth direction of the paper in Fig. 6. The carrying-out unit 58 carries out the obtained laminate 10 from the transport belt 51a to the transfer destination, for example, a storage container in the vicinity of the second roller 51c.

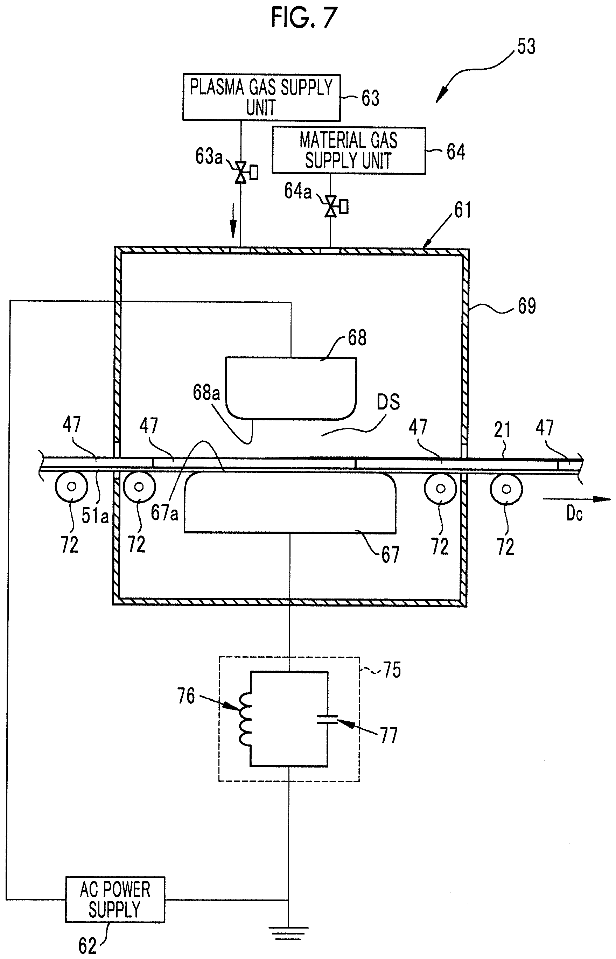

In Fig. 7, the layer forming apparatus 53 is a so-called atmospheric pressure plasma processing apparatus that generates plasma under atmospheric pressure. The layer forming apparatus 53 generates plasma by ionizing the supplied gaseous organosilicon compound (hereinafter referred to as organosilicon compound gas) under atmospheric pressure to form the silicon oxide layer 21. Since the layer forming apparatus 53 is an apparatus that generates plasma under atmospheric pressure, unlike a so-called reduced pressure (vacuum) plasma processing apparatus that generates plasma under reduced pressure, there is no need to reduce the pressure. As a result, the silicon oxide layer 21 is efficiently formed. Further, a plurality of silicon oxide layers 21 are efficiently and sequentially formed by arranging a plurality of layer forming apparatuses along the transport path of the plastic substrate 11, transporting the plastic substrate 11 and passing through the layer forming apparatuses 53. Therefore, the laminate 10 is efficiently manufactured.

The layer forming apparatus 53 comprises a plasma generating unit 61, an AC power supply (hereinafter, simply referred to as "power supply") 62, a plasma gas supply unit 63, and a material gas supply unit 64. The plasma gas supply unit 63 is connected to the plasma generating unit 61 and supplies a gas that generates plasma (hereinafter, referred to as plasma gas) to the plasma generating unit 61. As the plasma gas, for example, nitrogen (N₂) or rare gas (helium (He), argon (Ar)) is preferable, and nitrogen is used in the embodiment.

A valve 63a is provided in the pipe connecting the plasma gas supply unit 63 and the plasma generating unit 61. By adjusting the opening degree of the valve 63a, the flow rate (volume per unit time) of the plasma gas supplied to the plasma generating unit 61 is adjusted.

The material gas supply unit 64 is connected to the plasma generating unit 61 and supplies the organosilicon compound gas, which is the material of the silicon oxide layer 21, to the plasma generating unit 61. As the organosilicon compound, for example, tetraethyl orthosilicate (TEOS), tetramethyl orthosilicate (TMOS), or hexamethyldisiloxane (HMDSO) is preferable, and TEOS is used in the embodiment. A valve 64a is provided in the pipe connecting the material gas supply unit 64 and the plasma generating unit 61. By adjusting the opening degree of the valve 64a, the flow rate (volume per unit time) of the plasma gas supplied to the plasma generating unit 61 is adjusted. In addition to the plasma gas and the organosilicon compound gas, gas different from these may be supplied to the plasma generating unit 61 as auxiliary gas that assists the generation of plasma from the organosilicon compound gas, for example. As the auxiliary gas, for example, He or Ar is preferable.

The plasma generating unit 61 includes a first electrode 67, a second electrode 68, and a chamber 69 that accommodates the first electrode 67 and the second electrode 68. The plasma generating unit 61 generates plasma in a case where an AC voltage is applied between the first electrode 67 and the second electrode 68 under atmospheric pressure. The first electrode 67 and the second electrode 68 have flat facing surfaces 67a and 68a facing each other in the vertical direction, and are disposed such that the facing surface 67a and the facing surface 68a are substantially parallel to each other. In the embodiment, the lower electrode is the first electrode 67 and the upper electrode is the second electrode 68. The plasma generating unit 61 forms a discharge space DS for generating plasma between the first electrode 67 and the second electrode 68.

The plasma gas supply unit 63 and the material gas supply unit 64 are connected to the chamber 69, and the supplied plasma gas and gas such as organosilicon compound gas are introduced into the discharge space DS. The plasma generating unit 61 generates plasma by ionizing the gas introduced into the discharge space DS. In Fig. 7, gas introduction ports 69a and 69b to which the plasma gas supply unit 63 and the material gas supply unit 64 of the chamber 69 are connected are illustrated as being formed on the top plate, but the formation position of the gas introduction ports 69a and 69b is not limited thereto, and may be a side wall, for example.

It is preferable that the first electrode 67 and the second electrode 68 comprise a film-shaped dielectric (not shown) on each of the facing surfaces 67a and 68a, and the facing surfaces 67a and 68a also comprises the film-shaped dielectrics in the embodiment. These dielectrics form an electric field polarized in the opposite direction to the polarization of the electric field caused by plasma generated in the discharge space (so-called reverse electric field). As a result, the dielectric suppresses so-called abnormal discharge such as local generation of discharge current in a case where plasma is generated.

On the side wall of the chamber 69, openings 69c and 69d through which the transport belt 51a passes are formed. The transport belt 51a introduced from one opening 69c is moved while being in contact with the facing surface 67a of the first electrode 67. As described above, the transport belt 51a moves toward the other opening 69d while slidingly contacting the first electrode 67. While passing through the first electrode 67, the plasma generating unit 61 generates plasma in the discharge space DS to form the silicon oxide layer 21 on the surface of the intermediate 47 exposed to the discharge space DS side using the plasma. As shown in Fig. 7, the plasma generating unit 61 may be provided with a roller 72 that supports the transport belt 51a from below. The transport belt 51a in the embodiment is formed of a dielectric material, and the transport belt 51a also contributes to the suppression of abnormal discharge. In a case where the transport belt 51a is formed of a dielectric material as described above, the facing surface 67a of the first electrode 67, which is in contact with the transport belt 51a, may not be provided with a dielectric.

The power supply 62 generates an AC voltage having a specific frequency and a specific amplitude, and supplies the AC voltage to the plasma generating unit 61. The power supply 62 includes a transformer section (not shown) that steps up or down a voltage generated by the power supply body to a specific voltage, and/or a matching coil (not shown) for matching impedance in addition to a power supply body that generates a predetermined voltage. The power supply 62 generates, for example, a sinusoidal waveform AC voltage. The amplitude VI of the AC voltage is, for example, about 2000 volts ([V]). Further, it is preferable that the frequency of the AC voltage generated by the power supply 62 be at most 1 MHz. Since the frequency of the AC voltage is a low frequency of 1 MHz or smaller, the plasma generating unit 61 ionizes not only the gas formed of molecules that easily move, such as rare gas, but also the molecular gas that is harder to move than the rare gas, such as nitrogen and oxygen, or TEOS to generate plasma more reliably. The frequency of the AC voltage is more preferably in the range of 1 kHz or greater and 1 MHz or smaller, further preferably in the range of 20 KHz or greater and 500 KHz or smaller, and particularly preferably in the range of 200 KHz or greater and 400 KHz or smaller.

The input power of the plasma generating unit 61 of the layer forming apparatus 53 is preferably in the range of 1500 W or greater and 2000 W or smaller. The input power in the first layer forming apparatus 53A to the fourth layer forming apparatus 53D are preferably close to each other, and more preferably equal to each other. As a result, the variable range of the input power is limited, so that the apparatus cost can be suppressed and the condition setting can be simplified.

It is preferable to connect the LC circuit 75 having an inductor and a capacitor as a discharge stabilization circuit between the power supply 62 and the plasma generating unit 61, and the same configuration is applied to the embodiment. In the embodiment, the LC circuit 75 is a so-called LC juxtaposition circuit in which the inductor 76 having an inductance of "L" and the capacitor 77 having a capacitance of "C" are connected in parallel, and is connected between the power supply 62 and the plasma generating unit 61 in parallel. However, an impedance circuit or element having frequency dependency may be used instead of the LC circuit 75.

The first surface treatment apparatus 54A to the third surface treatment apparatus 54C are apparatuses that modify the exposed surface of the silicon oxide layer 21 by generating plasma. The first surface treatment apparatus 54A to the third surface treatment apparatus 54C have the same configuration as the layer forming apparatus 53 except that the size is smaller than the layer forming apparatus 53 in the embodiment example, therefore description thereof will be omitted. The surface treatment apparatus 54 may be the same size as the layer forming apparatus 53 or greater than the layer forming apparatus 53.

The input power in the plasma generating unit 61 of the surface treatment apparatus 54 is preferably in the range of 1000 W or greater and 1500 W or smaller, and is preferably smaller than the input power in the surface treatment apparatus 53. As a result, the surface treatment is performed without damaging the silicon oxide layer formed in the previous step, and a boundary layer is produced in the silicon oxide layer.

The effects of the above configuration of the silicon oxide film forming unit 50 will be described. With respect to the chamber 69 of the first layer forming apparatus 53A, with set flow rate, the plasma gas is supplied by the plasma gas supply unit 63, and the organosilicon compound gas is supplied by the material gas supply unit 64. The flow rate of the plasma gas is preferably in the range of 10 L/min (liter/minute) or greater and 30 L/min or smaller. The flow rate of the organosilicon compound is preferably in the range of 3 g/min or greater and 30 g/min or smaller. The above described auxiliary gas may be supplied to the chamber 69, and Ar is also used as the auxiliary gas in the embodiment and is supplied to the chamber 69.

The AC voltage is applied between the first electrode 67 and the second electrode 68 by the power supply 62, and as a result, plasma is generated from the plasma gas and the organosilicon compound gas, and the discharge space DS is formed. The intermediate 47 mounted on the transport belt 51a with the plastic substrate 11 facing downward is transported in a state of being in contact with the facing surface 67a of the first electrode 67. As a result, the film surface 13a of the resin film 13 exposed in the discharge space DS is covered with the silicon oxide generated by replacing the carbon-containing structural portion of the organosilicon compound gas with hydrogen, and the first silicon oxide layer 21A is formed on the film surface 13a (first silicon oxide layer forming step).

The plastic substrate 11 on which the first silicon oxide layer 21A is formed is guided to the first surface treatment apparatus 54A. Plasma gas is supplied to the first surface treatment apparatus 54A by the plasma gas supply unit 63. The supply flow rate is preferably the same as the flow rate of the plasma gas in the first layer forming apparatus 53A, and the same configuration is applied in the embodiment. Therefore, even in a case where the first layer forming apparatus 53A and the first surface treatment apparatus 54A have the same specifications, each process can be performed.

Also in the first surface treatment apparatus 54, plasma is generated under atmospheric pressure under the same conditions. However, in the first surface treatment apparatus 54A, it is preferable that the valve 64a be closed and the flow rate of the organosilicon compound gas from the material gas supply unit 64 be set to 0 (zero), and the same configuration is applied in the embodiment. That is, the organosilicon compound gas is not supplied. As a result, a dehydration condensation reaction of silicon oxide occurs in an area from the surface of the first silicon oxide layer 21A to a very small depth, and the area is the first boundary layer 25A. As described above, the first boundary layer 25A is produced on the exposed surface side of the first silicon oxide layer 21A (first boundary layer producing step). The flow rate of the organosilicon compound gas is not limited to 0 (zero), and since the dehydration condensation reaction in the first silicon oxide layer 21A occurs, it does not matter that a flow rate is greater than 0 g/min and 0.9 g/min or smaller. Thus, the flow rate of the organosilicon compound gas is preferably 0 g/min or greater and 0.9 g/min or smaller. The chamber 69 may or may not be supplied with the auxiliary gas described above. In the embodiment, auxiliary gas is supplied, and Ar is used as the auxiliary gas.

In the first surface treatment apparatus 54A, the effect of modifying the first silicon oxide layer 21A by plasma tends to weaken as away from the exposed surface of the first silicon oxide layer 21A in the thickness direction. Therefore, the density is maximum on the exposed surface of the first silicon oxide layer 21A, and the density continuously decreases gradually as away from the surface in the thickness direction. As a result, the first boundary layer 25A is obtained.

Similar conditions and effects can be obtained in the second surface treatment apparatus 54B and the third surface treatment apparatus 54C.

The plastic substrate 11 on which the first silicon oxide layer 21A and the first boundary layer 25A are formed is guided to the second layer forming apparatus 53B. With respect to the second layer forming apparatus 53B, the plasma gas is supplied by the plasma gas supply unit 63, and the organosilicon compound gas is supplied by the material gas supply unit 64.

The flow rate of the plasma gas for the second layer forming apparatus 53B is preferably equal to the flow rate of the plasma gas for the first layer forming apparatus 53A. Therefore, even in a case where the first layer forming apparatus 53A and the second layer forming apparatus 53B have the same specifications, each process can be performed.

The flow rate of the organosilicon compound gas is smaller than the flow rate of the supplied to the first layer forming apparatus 53A. Therefore, the second silicon oxide layer 21B having a smaller thickness than the first silicon oxide layer 21A is formed (second silicon oxide layer forming step).

According to this method, in forming each of the first silicon oxide layer 21A and the second silicon oxide layer 21B, the flow rate of the organosilicon compound gas, which is one of the film forming conditions, need only be changed by the first layer forming apparatus 53A and the second layer forming apparatus 53B. Therefore, as compared to continuously changing film forming conditions with one atmospheric pressure plasma processing apparatus, instability of discharge is suppressed, heat damage to the plastic substrate 11 is prevented, and the property of the silicon oxide layer 21 is stable. Since the instability of the discharge is suppressed, the occurrence of abnormal discharge is also suppressed, and the formed silicon oxide layer 21 is not damaged. Further, the silicon oxide layers 21 can be sequentially laminated by simply passing through the first layer forming apparatus 53A and the second layer forming apparatus 53B arranged in the transport path, so that the silicon oxide film 14 having a sufficient thickness to improve scratch resistance is formed. Further, since the second silicon oxide layer 21B is formed on the surface of the first boundary layer 25A produced by dehydration condensation, sufficient adhesive strength of the second silicon oxide layer 21B can be obtained.

The plastic substrate 11 on which the second silicon oxide layer 21B is formed is guided to the second surface treatment apparatus 54B. In the second surface treatment apparatus 54B, the second boundary layer producing step is performed similarly to the first boundary layer producing step in the first surface treatment apparatus 54A, and the second boundary layer 25B is produced in the second silicon oxide layer 21B.

The plastic substrate 11 on which the second boundary layer 25B is formed is guided to the third layer forming apparatus 53C. The plasma gas and the organosilicon compound gas are supplied to the third layer forming apparatus 53C, similarly to the first layer forming apparatus 53A and the second layer forming apparatus 53B. The flow rate of the plasma gas for the third layer forming apparatus 53C is preferably equal to the flow rate of the plasma gas for the second layer forming apparatus 53B. The flow rate of the organosilicon compound gas is smaller than the flow rate of the supplied to the second layer forming apparatus 53B. Therefore, the third silicon oxide layer 21C having a smaller thickness than the second silicon oxide layer 21B is formed (third silicon oxide layer forming step).

The plastic substrate 11 on which the third silicon oxide layer 21C is formed is guided to the third surface treatment apparatus 54C. In the third surface treatment apparatus 54C, the third boundary layer producing step is performed similarly to the first boundary layer producing step in the first surface treatment apparatus 54A, and the third boundary layer 25C is produced in the third silicon oxide layer 21C.

The plastic substrate 11 on which the third boundary layer 25C is formed is guided to the fourth layer forming apparatus 53D, and similarly, the plasma gas and the organosilicon compound gas are supplied. The flow rate of the plasma gas for the fourth layer forming apparatus 53D is preferably equal to the flow rate of the plasma gas for the third layer forming apparatus 53C, but the flow rate of the organosilicon compound gas is smaller than the flow rate supplied for the third layer forming apparatus 53C. Therefore, the fourth silicon oxide layer 21D having a smaller thickness than the third silicon oxide layer 21C is formed (fourth silicon oxide layer forming step) to obtain the laminate 10.

In the embodiment, since the laminate 10 comprising the first boundary layer 25A to the third boundary layer 25C is manufactured, the above manufacturing method has the first boundary layer producing step to the third boundary layer producing step. However, in a case where the boundary layer 25 is not provided, the above boundary layer producing step is omitted. Further, in a case where the silicon oxide layer is formed a plurality of times under the same condition without forming the boundary layer 25, the boundaries thereof are not visually recognized and the densities are the same, so that the silicon oxide layers are integrally formed. In a case where the silicon oxide layers are integrally formed, it is regarded as one silicon oxide layer. For example, in a case where the input power of the first surface treatment apparatus 54A is 0 (zero) and the conditions of the first layer forming apparatus 53A and the second layer forming apparatus 53B are the same, the first silicon oxide layer is formed by the first layer forming apparatus 53A and the second layer forming apparatus 53B, the second silicon oxide layer is formed by the third layer forming apparatus 53C, and the third silicon oxide layer is formed by the fourth layer forming apparatus 53D. Examples

### [Example 1] to [Example 6]

Using the coating unit 30 and the silicon oxide film forming unit 50, the laminate 10 was manufactured to obtain Examples 1 to 6. The conditions for forming each layer in the silicon oxide film forming unit 50 are shown in Table 1. In a case where in the first layer forming apparatus 53A to the fourth layer forming apparatus 53D and the first surface treatment apparatus 54A to the third surface treatment apparatus 54C, the processing was not performed by the apparatuses, "-" is described in the "input power" column in Table 1.

The obtained laminate 10 is shown in Table 2. In the two layer forming apparatuses 53, among the first layer forming apparatus 53A to the fourth layer forming apparatus 53D, which have not been subjected to the surface treatment apparatus 54 therebetween, since the silicon oxide layers were integrally formed, the silicon oxide layer is regarded as one. For example, in Example 4, the input power of the first surface treatment apparatus 54A and the second surface treatment apparatus 54B was set to 0 (zero), so that one silicon oxide layer was formed by the first layer forming apparatus 53A to the third layer forming apparatus 53C as the first silicon oxide layer. For each example, the manufacturing efficiency and the scratch resistance of the obtained laminate 10 were evaluated. The scratch resistance was evaluated by pencil hardness. The evaluation method and criteria are as follows. The evaluation results are shown in Table 2.

### 1. Manufacturing Efficiency

The manufacturing efficiency was evaluated by the transport speed. A and B means pass, and C means fail. Note that, "the transport speed differs depending on the process" means that since the moving speed of the transport belt 51a needs to be changed for each process, the processing process becomes complicated, and in a case where a plurality of laminates are sequentially manufactured, the trailing intermediate 47 is to be placed on the transport belt 51a in a state where the distance between the laminate and the preceding intermediate 47 is equal to or greater than the distance from the downstream end of the first layer forming apparatus 53A to the upstream end of the fourth layer forming apparatus 53D. Therefore, C means fail.
A: The transport speed is constant at 0.10 m/min or greater.
B: The transport speed is constant in the range of 0.08 m/min or greater and smaller than 0.10 m/min.
C: The transport speed is constant, but smaller than 0.08 m/min, or the transport speed varies depending on the process.

### 2. Pencil Hardness

The evaluation was performed according to the pencil hardness test specified in Japanese Industrial Standard JIS K5600-5-4. A case where the pencil hardness was 4H or greater was passed, and a case where the pencil hardness was 3H or smaller was rejected.

Furthermore, the adhesive strength was evaluated. The adhesive strength was evaluated based on the following evaluation criteria, with the evaluation result of Example 4 having a mesh having a peeled area as a standard level. In Table 2, it is described as "standard" in Example 4.
A: No peeled meshes were found, which was extremely good as compared with Example 4.
B: There were some meshes in which peeled areas were observed, but it was clearly better as compared with Example 4.
C: It was the same as in Example 4.
D: It was worse as compared with Example 4.

**[Table 1]**

| | | First layer forming apparatus | First surface treatment apparatus | Second layer forming apparatus | Second surface treatment apparatus | Third layer forming apparatus | Third surface treatment apparatus | Fourth layer forming apparatus |
|---|---|---|---|---|---|---|---|---|
| Comparative Example 1 | Input power (W) | 1700 | - | 1700 | - | 1700 | - | 1700 |
| | Transport speed (m/min) | 0.16 | | | | | | |
| | Flow rate (L/min) of plasma gas | 20 | | | | | | |
| | Flow rate (g/min) of organosilicon compound gas | 25.6 | 0 | 25.6 | 0 | 25.6 | 0 | 25.6 |
| Comparative Example 2 | Input power (W) | 1700 | - | 1700 | - | 1700 | - | 1700 |
| | Transport speed (m/min) | 0.04 | | | | | | |
| | Flow rate (L/min) of plasma gas | 20 | | | | | | |
| | Flow rate (g/min) of organosilicon compound gas | 3.2 | 0 | 3.2 | 0 | 3.2 | 0 3.2 | |
| Example 1 | Input power (W) | 1700 | 1500 | 1700 | 1500 | 1700 | 1500 | 1700 |
| | Transport speed (m/min) | 0.10 | | | | | | |
| | Flow rate (L/min) of plasma gas | 20 | | | | | | |
| | Flow rate (g/min) of organosilicon compound gas | 25.6 | 0 | 12.8 | 0 | 6.4 | 0 | 3.2 |
| Example 2 | Input power (W) | 1700 | - | 1700 | - | 1700 | - | 1700 |
| | Transport speed (m/min) | 0.10 | | | | | | |
| | Flow rate (L/min) of plasma gas | 20 | | | | | | |
| | Flow rate (g/min) of organosilicon compound gas | 25.6 | 0 | 12.8 | 0 | 6.4 | 0 | 3.2 |
| Example 3 | Input power (W) | 1700 | 1000 | 1700 | 1000 | 1700 | 1500 | 1700 |
| | Transport speed (m/min) | 0.10 | | | | | | |
| | Flow rate (L/min) of plasma gas | 20 | | | | | | |
| | Flow rate (g/min) of organosilicon compound gas | 25.6 | 0 | 12.8 | 0 | 6.4 | 0 | 3.2 |
| Example 4 | Input power (W) | 1700 | - | 1700 | - | 1700 | - | 1700 |
| | Transport speed (m/min) | 0.08 | | | | | | |
| | Flow rate (L/min) of plasma gas | 20 | | | | | | |
| | Flow rate (g/min) of organosilicon compound gas | 10.0 | 0 | 10.0 | 0 | 3.2 | 0 | 3.2 |
| Example 5 | Input power (W) | 1700 | - | 1700 | 1700 | 1700 | - | 1700 |
| | Transport speed (m/min) | 0.08 | | | | | | |
| | Flow rate (L/min) of plasma gas | 20 | | | | | | |
| | Flow rate (g/min) of organosilicon compound gas | 10.0 | 0 | 10.0 | 0 | 3.2 | 0 | 3.2 |
| Example 6 | Input power (W) | 1700 | 1700 | 1700 | 1700 | 1700 | 1700 | 1700 |
| | Transport speed (m/min) | 0.20 | | | | | | |
| | Flow rate (L/min) of plasma gas | 20 | | | | | | |
| | Flow rate (g/min) of organosilicon compound gas | 25.6 | 0 | 12.8 | 0 | 6.4 | 0 | 3.2 |
| Comparative Example 3 | Input power (W) | 1700 | 1700 | 1700 | 1700 | 1700 | 1700 | 1700 |
| | Transport speed (m/min) | 0.32 | | 0.24 | | 0.16 | | 0.08 |
| | Flow rate of plasma gas | 20 | | | | | | |
| | Flow rate (g/min) of organosilicon compound gas | 25.6 | 0 | 12.8 | 0 | 6.4 | 0 | 3.2 |

**[Table 2]**

| | First silicon oxide layer | | First boundary layer | Second silicon oxide layer | | Second boundary laver | Third silicon oxide layer | | Third boundary layer | Fourth silicon oxide layer | | Evaluation result | | |
|---|---|---|---|---|---|---|---|---|---|---|---|---|---|---|
| | Thickness (nm) | Density (g/cm³) | Density (g/cm³) | Thickness (nm) | Density (g/cm³) | Density (g/cm³) | Thickness (nm) | Density (g/cm³) | Density (g/cm³) | Thickness (nm) | Density (g/cm³) | Manufacturing efficiency | Pencil hardness | Adhesive strength |
| Comparative Example 1 | 2000 | 2.2 | - | - | - | - | - | - | - | - | - | A | 2H | - |
| Comparative Example 2 | 2000 | 2.7 | - | - | - | - | - | - | - | - | - | C | 6H | - |
| Example 1 | 800 | 2.0 | 2.2 | 600 | 2.2 | 2.4 | 380 | 2.5 | 2.6 | 200 | 2.7 | A | 6H | A |
| Example 2 | 800 | 2.0 | - | 600 | 2.2 | | 380 | 2.5 | | 200 | 2.7 | A | 6H | C |
| Example 3 | 800 | 2.0 | 2.1 | 600 | 2.2 | 2.3 | 380 | 2.5 | 2.6 | 200 | 2.7 | A | 6H | B |
| Example 4 | 1500 | 2.3 | - | 500 | 2.7 | - | - | - | - | - | - | B | 5H | Standard |
| Example 5 | 1500 | 2.3 | 2.6 | 500 | 2.7 | - | - | - | - | - | - | B | 5H | B |
| Example 6 | 400 | 2.0 | 2.2 | 300 | 2.2 | 2.4 | 190 | 2.5 | 2.6 | 100 | 2.7 | A | 4H | A |
| Comparative Example 3 | 250 | 2.0 | 2.2 | 250 | 2.2 | 2.4 | 250 | 2.5 | 2.6 | 250 | 2.7 | C | 6H | - |

### [Comparative Example 1] to [Comparative Example 3]

Laminates were manufactured under the conditions shown in Table 1 and used as Comparative Examples 1 to 3. For each comparative example, the manufacturing efficiency and the pencil hardness as the scratch resistance were evaluated by the same method and standard as those of the examples. Since the adhesive strength was not evaluated, "-" is written in the "Adhesive strength" column of Table 2.

### Explanation of References

10: laminate
10a: first surface
11: plastic substrate
12: base layer
12A: coating film
13: resin film
13a: film surface
13A: coating film
14: silicon oxide film
14a: first film surface
14b: second film surface
17: hard coat portion
21: silicon oxide layer
21A to 24D: first silicon oxide layer to fourth silicon oxide layer
25A to 25C: first boundary layer to third boundary layer
30: coating unit
31: delivery device
32: winding device
35: first coating die
35a: outflow port
36: drying unit
37: second coating die
38: light source
40a, 40b: winding core
41: substrate roll
44: roller
45: base layer coating liquid
46: intermediate roll
47: intermediate
50: silicon oxide film forming unit
51: transport unit
51a: transport belt
51b, 51c: first roller, second roller
53: layer forming apparatus
53A to 53D: first layer forming apparatus to fourth layer forming apparatus
54A to 54C: first surface treatment apparatus to third surface treatment apparatus
57: supply unit
58: carrying-out unit
61: plasma generating unit
62: power supply
63: plasma gas supply unit
63a: valve
64: material gas supply unit
64a: valve
67, 68: first electrode, second electrode
67a, 68a: facing surface
69: chamber
69a, 69b: gas introduction port
69c, 69d: opening
72: roller
75: LC circuit
76: inductor
77: capacitor
Dc: transport direction
Ds: discharge space
T11 to T14, T21A to T21D, T25A to T25C: thickness

## Claims

1. A laminate comprising:
a plastic substrate;
a resin film that is provided on the plastic substrate and formed of a cured resin;
a first silicon oxide layer that is provided on a film surface of the resin film on an opposite side from the plastic substrate; and
a second silicon oxide layer that is provided on the first silicon oxide layer, and has a greater density and a smaller thickness than the first silicon oxide layer.

2. The laminate according to claim 1, wherein the first silicon oxide layer has a density in a range of 1.7 g/cm³ or greater and 2.3 g/cm³ or smaller, and a thickness of at least 300 nm.

3. The laminate according to claim 1 or 2,
wherein a silicon oxide film in which at least two silicon oxide layers including the first silicon oxide layer and the second silicon oxide layer are laminated in a thickness direction is provided, and
the silicon oxide layer that forms a film surface of the silicon oxide film on an opposite side from the resin film has a density in a range of 2.6 g/cm³ or greater and 2.8 g/cm³ or smaller and a thickness of at most 500 nm.

4. The laminate according to any of claims 1 to 3, further comprising a first boundary layer between the first silicon oxide layer and the second silicon oxide layer,
wherein the first boundary layer is formed of silicon oxide, and has a smaller thickness than the first silicon oxide layer and the second silicon oxide layer and a density greater than a density of the first silicon oxide layer and in a range of 95% or greater and 105% or smaller of a density of the second silicon oxide layer.

5. The laminate according to claim 4, wherein the first boundary layer has a density that gradually increases from the first silicon oxide layer side to the second silicon oxide layer side.

6. The laminate according to claim 5,
wherein the silicon oxide film further includes
a third silicon oxide layer that is provided on the second silicon oxide layer, and has a greater density and a smaller thickness than the second silicon oxide layer, and
a second boundary layer that is provided between the second silicon oxide layer and the third silicon oxide layer, formed of silicon oxide, and has a smaller thickness than the second silicon oxide layer and the third silicon oxide layer and a density greater than a density of the second silicon oxide layer and in a range of 95% or greater and 105% or smaller of a density of the third silicon oxide layer.

7. The laminate according to claim 6, wherein the second boundary layer has a smaller thickness than the first boundary layer.

8. A laminate manufacturing method for forming a silicon oxide layer while transporting a plastic substrate having a resin film formed of a cured resin, the method comprising:
a resin film forming step of applying a coating liquid containing a curable compound on the plastic substrate and curing the applied coating film form the resin film;
a first silicon oxide layer forming step of transporting the plastic substrate on which the resin film is formed to a first layer forming apparatus which forms the silicon oxide layer by supplying a gaseous organosilicon compound and generating plasma under atmospheric pressure, and forming a first silicon oxide layer on a film surface of the resin film; and
a second silicon oxide layer forming step of forming a second silicon oxide layer on the first silicon oxide layer by a second layer forming apparatus disposed downstream of the first layer forming apparatus in a transport direction of the plastic substrate,
wherein the organosilicon compound is supplied to the second layer forming apparatus with a flow rate smaller than a flow rate with respect to the first layer forming apparatus.

9. The laminate manufacturing method according to claim 8, wherein the first layer forming apparatus and the second layer forming apparatus have a power supply for applying an alternating current voltage, and a frequency of the alternating current voltage is at most 1 MHz.

10. The laminate manufacturing method according to claim 8 or 9, wherein the plastic substrate on which the first silicon oxide layer is formed is guided to a surface treatment apparatus that is disposed between the first layer forming apparatus and the second layer forming apparatus, and generates plasma to reform a surface of the silicon oxide layer, and a flow rate of the organosilicon compound supplied to the surface treatment apparatus is made to 0 g/min or greater and 0.9 g/min or smaller to produce, on the first silicon oxide layer, a boundary layer that has a smaller thickness than the first silicon oxide layer and the second silicon oxide layer, and a density greater than a density of the first silicon oxide layer and in a range of 95% or greater and 105% or smaller of a density of the second silicon oxide layer.
